# EUROPÄISCHE PATENTSCHRIFT

(11) **EP 1 525 628 B1**
(45) Veröffentlichungstag und Bekanntmachung des Hinweises auf die Patenterteilung: **30.05.2007**
(21) Anmeldenummer: 03762483.0
(22) Anmeldetag: 06.06.2003
(51) Int. Cl.: H01L 41/053, F02M 59/46, F16K 31/00

(54) **PIEZOELEKTRISCHER AKTOR FÜR UMSTRÖMENDE MEDIEN SOWIE VERWENDUNG EINES ENTSPRECHENDEN PIEZOELEKTRISCHEN AKTORS**
PIEZOELECTRIC ACTUATOR FOR MEDIA FLOWING THEREAROUND, AND USE OF A CORRESPONDING PIEZOELECTRIC ACTUATOR
ACTIONNEUR PIEZO-ELECTRIQUE POUR DES MILIEUX S'ECOULANT AUTOUR DE LUI ET UTILISATION D'UN TEL ACTIONNEUR PIEZO-ELECTRIQUE

(30) Priorität: 04.07.2002 DE 10230032
(43) Veröffentlichungstag der Anmeldung: 27.04.2005
(73) Patentinhaber: DaimlerChrysler AG, 70327 Stuttgart (DE)
(72) Erfinder: FLÄMIG-VETTER, Tobias, 73733 Esslingen (DE); ÖING, Heinz, 26892 Dörpen (DE); RENNER, Gregor, 70619 Stuttgart (DE)
(86) Internationale Anmeldenummer: PCT/EP2003/005964
(87) Internationale Veröffentlichungsnummer: WO 2004/006348

(56) Entgegenhaltungen:
- DE-A- 19 818 068
- DE-C- 3 932 966
- DE-C- 19 642 653
- US-A- 4 553 059

## Beschreibung

Die Erfindung betrifft einen piezoelektrischen Aktor für umströmte Medien gemäß dem Oberbegriff des Anspruchs 1, wie er bspw. aus der gattungsbildend zugrundegelegten US 4,553,059 A1 als bekannt hervorgeht sowie Verwendungen desselben.

Aus der gattungsbildend zugrundegelegten US 4,553,059 A1 ist ein piezoelektrischer Aktor für umströmte Medien bekannt. Der Aktor weist u.a. einen Piezostapel, der mit direktem Kontakt zumindest bereichsweise innerhalb einer formveränderlichen Isolationsmasse angeordnet ist. Die Isolationsmasse ist ihrerseits von einem fluidisch verschlossenen Aktorgehäuse umfasst, welches von einem Gehäusemantel und einem damit verbundenen formstabilen Aktordeckel und ebenfalls damit verbundenen formstabilen Aktorboden gebildet wird. Der Aktordeckel bzw. der Aktorboden sind an den aktiven Hauptflächen des Piezostapel angeordnet, wobei die elektrischen Anschlussleitungen des Piezostapels über oder unter Zuhilfenahme des Aktordeckel und/oder des Aktorboden aus dem Aktorgehäuse nach außen geführt sind. Der Gehäusemantel ist aus einem lappigen und/oder elastischen Material gefertigt und zumindest weitgehend resistent gegenüber dem ihn umströmenden Medium, insbesondere Kraftstoff. Ferner weist der Gehäusemantel an allen Punkten einen Abstand von dem Piezostapel auf, wobei die entlang der Mantellinie gemessene Mantellänge des Gehäusemantels mindestens der Maximalausdehnung des Piezostapels entspricht und/oder der Gehäusemantel entsprechend dehnbar ist. In sinnvoller Weise ist das Material des Gehäusemantels des Weiteren elektrisch neutral. Das Innenvolumen des Aktorgehäuses ist zumindest weitgehend mit einer Isolationsmasse gefüllt, wozu der Gehäusemantel und der Aktorboden und der Aktordeckel gegenüber der Isolationsmasse und dem umströmenden Medium dichtend miteinander verbunden sind. Weiterhinhin ist die Isolationsmasse ein elektrisch isolierendes Fluid und/oder ein Gel, deren Wärmeleitfähigkeit gleich oder größer als die des Materials des Piezostapels ist.

DE 198 18 068 A1 ist ein piezoelektrischer Aktor für umströmte Medien bekannt, welcher einen Piezostapel aufweist, der innerhalb einer formveränderlichen Isolationsmasse aus einem elastischen Kunststoff mit direktem Kontakt zu dieser angeordnet ist. Die Isolationsmasse ist ihrerseits von einem Aktorgehäuse umfasst. Das Aktorgehäuse wird von einem Gehäusemantel gebildet, der an seinem einen Ende mit einem formstabilen Aktordeckel und an seinem anderen Ende mit einem formstabilen Aktorboden verbunden ist. Der Aktordeckel bzw. der Aktorboden sind mit den aktiven Hauptflächen des Piezostapels verbunden. Die elektrischen Anschlussleitungen des Piezostapels sind durch den Aktordeckel hindurchgeführt. Des weiteren ist es denkbar, die elektrischen Anschlüsse des Piezostapels bis an die Endplatten (Aktordeckel bzw. Aktorboden) des Aktors heranzuführen und eine oder beide Endplatten als elektrische Kontaktflächen zu nutzen.

Da die elektrisch isolierende Isolationsmasse aus einem elastischen Kunststoff, z.B. Silicon, gebildet ist, der direkt an der Außenfläche des Piezostapels anliegt, muss sie der sehr schnellen Bewegung des Piezostapels im Einsatz folgen. Hierdurch besteht die Gefahr einer Rissbildung in der Isolationsmasse sowie der Ablösungen von Isolationsmasse, so dass das umströmende Medium in zerstörerischer Weise an den Piezostapel gelangen kann.

Die Aufgabe der Erfindung ist es, die Standzeit derartiger Aktoren für umströmende Medien zu erhöhen.

Die Aufgabe wird mit einem Aktor mit den Merkmalen des Anspruchs 1 gelöst. Durch die Ausführung des Gehäusemantels aus einem lappigen und/oder elastischen Material mit den beanspruchten Merkmalen wird die hermetische Trennschicht weg von der hochaktiven Fläche des Piezostapels verlagert. Dadurch sind u.a. die Abnützungserscheinungen zwischen dem insbesondere eine piezoelektrische Keramik aufweisenden Piezostapel und der Isolationsmasse zumindest verringert. Dies wird ferner durch einfache konstruktive Maßnahmen erreicht, so dass auf aufwendige Konstruktionen zur Abdichtung verzichtet werden kann.

Ein erfindungsgemäßer Aktor ermöglicht damit eine freie Längenänderung des Aktors, respektive des Piezostapels, wobei eine Benetzungswahrscheinlichkeit des Piezostapels mit einem insbesondere aggressiven umströmenden Medium, vorzugsweise einem unter Druck stehenden Kraftstoff, zumindest verringert wird.

Der Gehäusemantel weist an allen Punkten einen Abstand von dem Piezostapel auf. Ferner entspricht die entlang der Mantellinie gemessene Mantellänge des Gehäusemantels mindestens der Maximalausdehnung des Aktors und/oder bzw. der Gehäusemantel ist mindestens entsprechend dehnbar, damit die Ausdehnung des Piezostapels seitens des Gehäusemantels wahrgenommen werden kann.

Da die Isolationsmasse weitgehend aus einem inkompressiblen Medium gebildet wird, ist dessen Formveränderung, bspw. die Ausbildung einer Taille bei der Ausdehnung des Piezostapels, bei der Dimensionierung der Länge des Gehäusemantels insbesondere in Richtung der Ausdehnung des Piezostapels zu berücksichtigen.

Des Weiteren ist zwischen dem Gehäusemantel und dem Piezostapel als Isolationsmasse ein elektrisch isolierendes Fluid, insbesondere eine Flüssigkeit, und/oder ein Gel eingebracht, wobei die Isolationsmasse, insbesondere ein Siliconöl, zumindest weitgehend das Innenvolumen des Aktorgehäuses füllt. Damit ist das Innenvolumen des Aktorgehäuses zumindest weitgehend frei von einem kompressiblen Gas.

Bei dem beanspruchten Aufbau weist einzig die fluidische Isolationsmasse einen Kontakt zu dem Piezostapel auf. Daher sind die hier auftretenden Scherkräfte allenfalls gering, womit die Standzeit des Aktors erhöht ist. Vor diesem Hintergrund ist es ferner von Vorteil, wenn die Isolationsmasse zur Abfuhr ggf. auftretender Reibungswärme zwischen dem Piezostapel und ihr, eine gute bis hohe Wärmeleitfähigkeit aufweist.

Gleiches gilt für die Wärmeabfuhr aus dem Piezostapel, weshalb die Wärmeleitfähigkeit der Isolationsmasse vorzugsweise gleich oder größer als die des Materials des Piezostapels ist.

In vorteilhafter Weise gilt dasselbe für die Wärmeleitfähigkeit der beiden Endplatten (Aktordeckel und Aktorboden), wodurch die Ableitung der im aktiven Betrieb anfallenden Wärme an das umströmende Medium erleichtert und/oder verbessert ist.

Da die den Aktor umströmenden Medien, insbesondere Kraftstoff zum Betrieb einer Brennkraftmaschine, durchaus chemisch oder auf andere Weise einen aggressiven Charakter aufweisen können, wird als Material des Gehäusemantels in zweckmäßiger Weise ein gegenüber diesen zu erwartenden Beanspruchungen zumindest weitgehend resistentes Material gewählt.

In günstiger Weise entspricht die Viskosität des Isolationsmediums in etwa der des umströmenden Mediums, da dadurch die Belastung des Material des Gehäusemantels seitens des umströmenden Mediums weiter verringert ist.

Insbesondere bei der Verwendung von Aktoren, deren Endplatte(n) als elektrische Kontakte verwendet werden, handelt es sich bei dem Material des Gehäusemantels in sinnvoller Weise um ein elektrisch isolierendes Material.

Je nach Anwendungsfall, bspw. in der Hydraulik, ist es günstig, den Aktordeckel gegenüber dem Aktorboden mit einer unterschiedlichen Querschnittsfläche auszubilden. In weiterführender Weise weist der Aktordeckel und/oder der Aktorboden eine Querschnittsfläche auf, die den jeweiligen Einsatzbedingungen angepasst ist.

Ein bevorzugter Einsatz erfindungsgemäßer Aktoren ist in einem und/oder als ein Einspritzventil, insbesondere einer Brennkraftmaschine, vorzugsweise in einem Otto- oder Dieselmotor. Ferner kann ein derartiger Aktor auch für ein Proportionalventil und/oder für eine Sonotrode verwendet werden.

Sinnvolle Ausgestaltungen sind den Unteransprüchen entnehmbar. Im übrigen wird die Erfindung anhand von in den Figuren dargestellten Ausführungsbeisielen näher erläutert. Dabei zeigt
- Fig. 1: eine Explosionsdarstellung eines Aktors,
- Fig. 2: einen in einem Medium angeordneten Aktor nach Figur 1 in entspanntem Zustand,
- Fig. 3: den Aktor nach Figur 1 in vollständig ausgedehnten Zustand,
- Fig. 4: ein Aktors mit geöffnetem Aktordeckel und aus dem Aktorgehäuse einseitig herausgeführten elektrischen Leitungen,
- Fig. 5: eine Aktors mit an beiden Endplatten angeordneten elektrischen Leitungen,
- Fig. 6: eine Aktor mit unterschiedlichen Endplatten und elastischem Material für den Gehäusemantel und
- Fig. 7: den Aktor nach Figur 6 mit ausgedehntem Piezostapel.

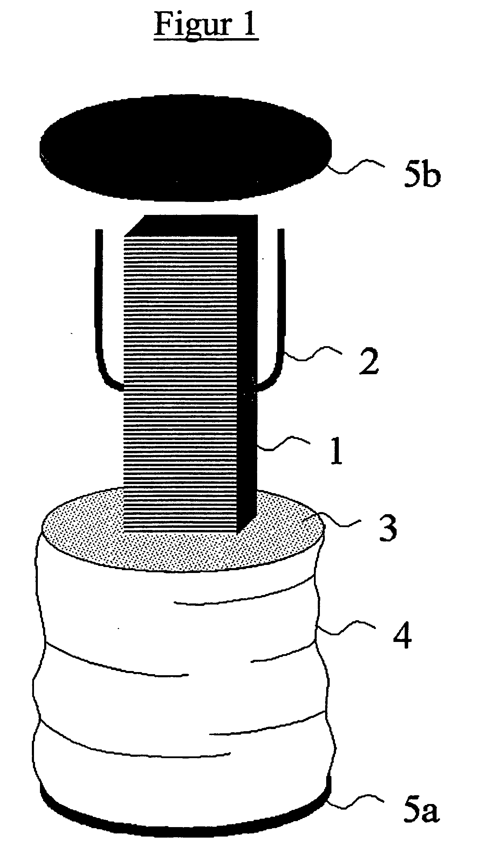

In Figur 1 ist eine Explosionszeichnung eines erfindungsgemäßen Aktors dargestellt. Der Aktor weist in seinem Inneren einen mittig angeordneten Piezostapel 1 aus mehreren Lagen von Piezofolien aus einer piezoelektrischen Keramik auf.

Der Piezostapel 1 ist von einer elektrisch isolierenden Isolationsmasse 3, insbesondere einem Siliconöl, umgeben. Die Isolationsmasse 3 ist außenseitig von einem Gehäusemantel 4 umgeben, der gegenüber der Isolationmasse 3 dicht verschlos ist.

An den aktiven Hauptflächen des Piezostapels 1 ist einerseits ein formstabiler Aktordeckel 5b und andererseits ein formstabiler Aktorboden 5a vorzugsweise äquidistant zueinander angeordnet.

Der Aktorboden 5a und der Aktordeckel 5b sind beide hinsichtlich der Isolationsmasse 3 sowie hinsichtlich des umströmenden Mediums dichtend mit dem Gehäusemantel 4 verbunden. Aktorboden 5a, Aktordeckel 5b und Gehäusemantel 4 bilden zusammen ein zumindest gegenüber der Isolationsmasse 3 und dem umströmendem Medium dichtes Aktorgehäuse.

An den Aktordeckel 5b sind elektrische Anschlußleitung 2 geführt, die beide mit Bereichen des Aktordeckels 5b elektrisch leitend, aber dennoch gegenüber einander isolierend verbunden sind. Jeweils eine der Anschlußleitungen 2 ist mit gleichpoligen Bereichen der Piezofolien verbunden. Sie dienen zur Spannungsversorgung und zur Steuerung der Ausdehnung des Piezostapels 1. Auf diese Weise stellen die entsprechenden mit diesen Anschlußleitungen 2 verbundenen Bereiche des Aktordeckels 5b Kontaktflächen zur elektrischen Steuerung des Aktors dar.

Der Gehäusemantel 4 besteht im vorliegenden Ausführungsbeispiel aus einem lappigen, vorzugsweise reissfesten Material. Er weist an allen Punkten einen nicht notwendigerweise gleichbleibenden Abstand von dem Piezostapel 1 auf.

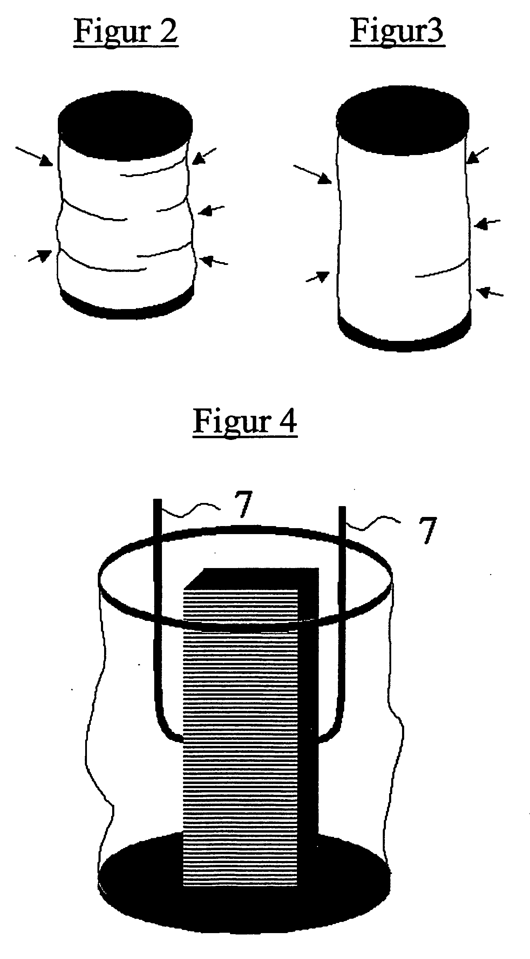

In Figur 2 und 3 ist der Aktor nach Figur 1 in einem umströmenden und unter Druck (siehe Pfeile) stehenden Kraftstoff für Brennkraftmaschinen, vorzugsweise Otto- oder Dieselmotoren, dargestellt. In zusammengefahrenem Zustand ist der aus lappigem Material gefertigte Gehäusemantel 4 von unregelmäßiger sowie axial (entlang der Hauptausdehnungsrichtung des Piezostapels 1) und radial zusammengeschobener bzw. - gedrückter Form (siehe Figur 2). Bei vollständiger Ausdehnung des Piezostapels 1 (siehe Figur 3) wird der Gehäusemantel 4 gestreckt und nähert sich einem geraden Verlauf an.

Wie ersichtlich entspricht die entlang der Mantellinie gemessene Mindesthöhe des Gehäusemantels 4 mindestens der entsprechenden Maximalausdehnung des Aktors. Die genannt Mindesthöhe beinhaltet auch einen Ausgleich einer Formveränderung der Isolationsmasse 3, wie sie bei einer Ausdehnung des Piezostapels zumindest auftreten kann.

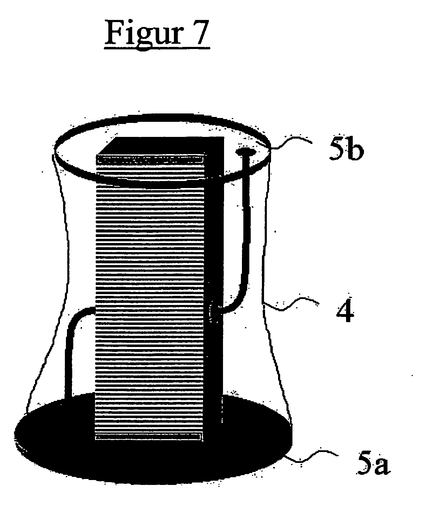

Die Formänderung der flüssigen und/oder gel-artigen Isolationsmasse 3, vorzugsweise eines Siliconöl, beruht auf der Inkompressibilität von Flüssigkeiten. Da bei einer Ausdehnung des Piezostapels 1 das Volumen einer inkompressiblen Isolationsmasse 3 gleichbleibt, muss sich ihre Form ändern. Dies kann bspw. - wie in Figur 7 - dargestellt von zylindrisch nach zylindrisch tailliert erfolgen.

Daraus ergibt sich, dass die Minimallänge des Mantels zumeist etwas größer ist als der Abstand der beiden Endplatten 5 bei vollständig ausgedehntem Piezostapel 1 (siehe Figur 2 und 3). Der Ausgleich sollte bei einem rein lappigen und unelastischen Material schon bei der Längenbemessung für den Gehäusemantel berücksichtigt werden. Bei einem elastischen Material kann die Ausgleichslänge und/oder der Hub des Piezostapels 1 insbesondere allein durch die Elastizität des Materials aufgebracht werden.

Das Ausführungsbeispiel gemäß Figur 4 ist in weiten Teilen gleichartig zu demjenigen nach den vorhergegangenen Figuren ausgebildet. Die Darstellung ist jedoch ohne Aktordeckel 5b und ohne Isolationsflüssigkeit dargestellt. Bei diesem Ausführungsbeispiel sind die Steuerleitungen 7 jedoch durch den - nicht gezeichneten - Aktordeckel 5b hindurch direkt und elektrisch isoliert voneinander nach außen geführt.

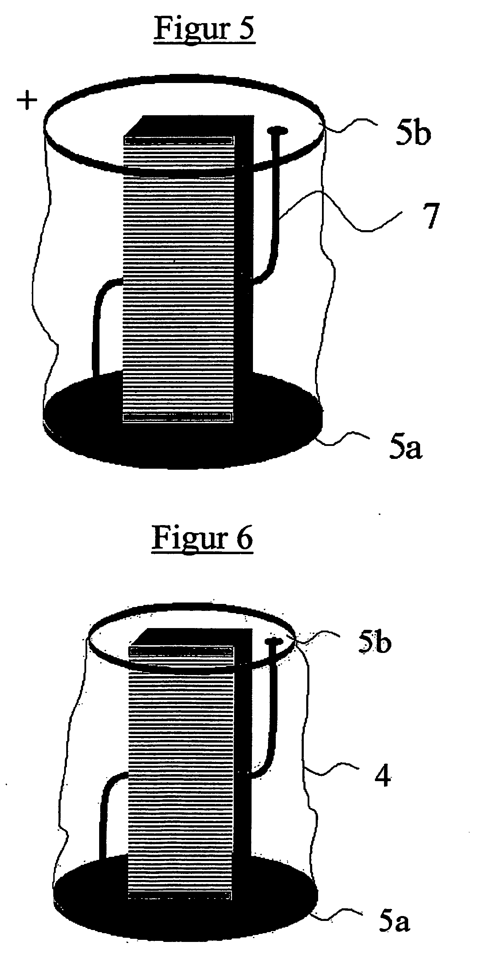

In dem Ausführungsbeispiel nach Figur 5 hingegen ist eine Anschlußleitung mit dem Aktorboden 5a und die andere mit dem Aktordeckel 5b elektrisch leitend verbunden. Der Gehäusemantel 4 ist aus einem elektrisch isolierenden Material gefertigt.

In Figur 6 und 7 sind Aktoren dargestellt, deren Aktorboden 5a und Aktordeckel 5b einen unterschiedlichen Querschnitt aufweisen. Gleichzeitig dienen die Endplatten als elektrische Anschlüsse für den Piezostapel 1. Der Gehäusemantel 4 ist aus einem Material gefertigt, das elektrisch isolierend und elastisch ist. Im entspannten Zustand (Spannung gleich Null) des Piezostapels 1 ist die Mantellänge des Gehäusemantels größer als der Abstand zwischen den beiden mit ihnen dichtend verbundenen Endplatten 5, so daß der Gehäusemantel einen lappigen Eindruck erweckt.

Im vollständig ausgedehnten Zustand des Piezostapels 2 (siehe Figur 7 verläuft die Mantellinie des Gehäusemantels 4 zwischen den beiden Endplatten 5 nicht geradlinig, sondern weist aus den oben genannten Gründen eine Taille auf.

Bei dem vorliegenden elastischen Material des Gehäusemantels 4, der zusätzlich noch lappig angebracht ist, wird bei diesem Ausführungsbeispiel die Ausgleichslänge durch die gegenüber der zusammengezogenen Stellung des Piezostapels 1 größere Mantellänge sowie durch die Elastizität des Materials des Gehäusemantels 4 aufgebracht.

## Patentansprüche

1. Piezoelektrischer Aktor für umströmte Medien, mit einem Piezostapel (1), der mit direktem Kontakt zumindest bereichsweise innerhalb einer formveränderlichen Isolationsmasse (3) angeordnet ist, die ihrerseits von einem fluidisch verschlossenen Aktorgehäuse umfasst ist, welches von einem Gehäusemantel (4) und einem damit verbundenen formstabilen Aktordeckel (5b) und ebenfalls damit verbundenen formstabilen Aktorboden (5a) gebildet wird, wobei der Aktordeckel bzw. der Aktorboden an den aktiven Hauptflächen des Piezostapel angeordnet sind, und bei welchen Aktor die elektrischen Anschlussleitungen des Piezostapels über oder unter Zuhilfenahme des Aktordeckel und/oder des Aktorboden aus dem Aktorgehäuse nach außen geführt sind,
wobei der Gehäusemantel aus einem lappigen und/oder elastischen Material gefertigt ist,
wobei das Material des Gehäusemantels zumindest weitgehend resistent gegenüber dem ihn umströmenden Medium, insbesondere Kraftstoff ist,
wobei der Gehäusemantel an allen Punkten einen Abstand von dem Piezostapel aufweist,
wobei die entlang der Mantellinie gemessene Mantellänge des Gehäusemantels mindestens der Maximalausdehnung des Piezostapels entspricht und/oder der Gehäusemantel entsprechend dehnbar ist,
wobei das Material des Gehäusemantels elektrisch isolierend ist,
wobei das Innenvolumen des Aktorgehäuses zumindest weitgehend mit der Isolationsmasse gefüllt ist,
wobei der Gehäusemantel und der Aktorboden und der Aktordeckel gegenüber der Isolationsmasse und dem umströmenden Medium dichtend miteinander verbunden sind,
wobei die Isolationsmasse ein elektrisch isolierendes Fluid und/oder ein Gel ist, und
wobei die Wärmeleitfähigkeit der Isolationsmasse gleich oder größer als die des Materials des Piezostapels ist,
**dadurch gekennzeichnet,**
**dass** das Innenvolumen des Aktorgehäuses zumindest weitgehend gasfrei ist und
**dass** die Viskosität des Isolationsmediums (3) in etwa der des umströmenden Mediums entspricht.

2. Piezoelektrischer Aktor nach Anspruch 1,
**dadurch gekennzeichnet,**
**dass** der Piezostapel (3) piezoelektrische Keramik aufweist.

3. Piezoelektrischer Aktor nach Anspruch 1,
**dadurch gekennzeichnet,**
**dass** der Aktordeckel (5a) und der Aktorboden (5b) äquidistant zueinander angeordnet sind.

4. Piezoelektrischer Aktor nach Anspruch 1,
**dadurch gekennzeichnet,**
**dass** der Aktordeckel (5a) und der Aktorboden (5b) eine unterschiedliche Querschnittsfläche aufweisen.

5. Piezoelektrischer Aktor nach Anspruch 1,
**dadurch gekennzeichnet,**
**dass** die Isolationsmasse (3) ein Siliconöl ist.

6. Piezoelektrischer Aktor nach Anspruch 1,
**dadurch gekennzeichnet,**
**dass** der Aktordeckel (5a) und/oder der Aktorboden (5b) eine Querschnittsfläche aufweisen, die jeweils der zugeordneten und quer zur Hauptausdehnungsrichtung des Piezostapels (1) angeordneten Aktivfläche des Piezostapels (1) entspricht.

7. Piezoelektrischer Aktor nach Anspruch 1,
**dadurch gekennzeichnet,**
**dass** der Aktorboden (5a) und/oder der Aktordeckel (5b) mindestens zwei voneinander elektrisch isolierte Abschlußbereiche für die elektrischen Anschlussleitungen (2) des Piezostapels (1) aufweisen.

8. Verwendung eines piezoelektrischen Aktors nach Anspruch 1 für ein Einspritzventil, insbesondere einer Brennkraftmaschine, vorzugsweise einem Otto- oder Dieselmotor.

9. Verwendung eines piezoelektrischen Aktors nach Anspruch 1 für ein Proportionalventil.

10. Verwendung eines piezoelektrischen Aktors nach Anspruch 1 für eine Sonotrode.

## Claims

1. Piezoelectric actuator for media flowing therearound, comprising a piezo stack (1), which is arranged with direct contact at least in regions inside a deformable insulating compound (3), which is in turn enclosed by a fluid-tight actuator housing, which is formed by a housing shell (4) and a dimensionally stable actuator top (5b) connected thereto and a dimensionally stable actuator base (5a) also connected thereto, wherein the actuator top or the actuator base are arranged on the active main faces of the piezo stack, and in which actuator the electric connection lines of the piezo stack are guided outwardly out of the actuator housing via or with the aid of the actuator top and/or the actuator face, wherein the housing shell is manufactured from a limp and/or elastic material, wherein the material of the housing shell is at least substantially resistant to the medium flowing around it, in particular fuel, wherein the housing shell has a spacing from the piezo stack at all points, wherein the shell length, measured along the shell line, of the housing shell corresponds at least to the maximum extension of the piezo stack and/or the housing shell is correspondingly extensible, wherein the material of the housing shell is electrically insulating, wherein the inner volume of the actuator housing is at least substantially filled with the insulating compound, wherein the housing shell and the actuator base and the actuator top are connected to one another so as to be sealed with respect to the insulating compound and the medium flowing therearound, wherein the insulating compound is an electrically insulating fluid and/or a gel, and wherein the heat conductivity of the insulating compound is equal to or greater than that of the material of the piezo stack, **characterised in that** the inner volume of the actuator housing is at least substantially gas-free and **in that** the viscosity of the insulating medium (3) approximately corresponds to the medium flowing therearound.

2. Piezoelectric actuator according to claim 1, **characterised in that** the piezo stack (3) has piezoelectric ceramic.

3. Piezoelectric actuator according to claim 1, **characterised in that** the actuator top (5a) and the actuator base (5b) are arranged equidistant with respect to one another.

4. Piezoelectric actuator according to claim 1, **characterised in that** the actuator top (5a) and the actuator base (5b) have a different cross-sectional area.

5. Piezoelectric actuator according to claim 1, **characterised in that** the insulating compound (3) is a silicone oil.

6. Piezoelectric actuator according to claim 1, **characterised in that** the actuator top (5a) and/or the actuator base (5b) have a cross-sectional area, which, in each case, corresponds to the associated active face of the piezo stack (1), which face is arranged transverse to the main extension direction of the piezo stack (1).

7. Piezoelectric actuator according to claim 1, **characterised in that** the actuator base (5a) and/or the actuator top (5b) have at least two terminating regions, which are electrically insulated from one another, for the electrical connection lines (2) of the piezo stack (1).

8. Use of a piezoelectric actuator according to claim 1 for an injection valve, in particular of an internal-combustion engine, preferably an Sl engine or diesel engine.

9. Use of a piezoelectric actuator according to claim 1 for a proportional valve.

10. Use of a piezoelectric actuator according to claim 1 for a sonotrode.

## Revendications

1. Actionneur piézo-électrique pour fluides circulant autour, avec une pile piézo-électrique (1), qui est disposée avec un contact direct au moins par endroits à l'intérieur d'une masse d'isolation (3) variable en forme, qui pour sa part est entourée par un boîtier d'actionneur fermé de façon fluidique, qui est formé par une enveloppe de boîtier (4) et un couvercle d'actionneur (5b) indéformable et relié à l'enveloppe et également par un fond d'actionneur (5a) indéformable et relié au couvercle, le couvercle d'actionneur et le fond d'actionneur étant disposés sur les surfaces principales actives de la pile piézo-électrique, et sur lequel actionneur les conduites de branchements électriques de la pile piézo-électrique sont guidées à partir du boîtier d'actionneur vers l'extérieur en ayant recours au couvercle d'actionneur et/ou au fond d'actionneur,
l'enveloppe de boîtier étant fabriquée à partir d'un matériau flasque et/ou élastique,
le matériau de l'enveloppe de boîtier étant au moins largement résistant vis-à-vis du fluide qui l'entoure, en particulier du carburant,
l'enveloppe du boîtier présentant en tous points une distance à la pile piézo-électrique,
la longueur d'enveloppe, mesurée le long de la ligne d'enveloppe, de l'enveloppe de boîtier correspondant au moins à l'extension maximale de la pile piézo-électrique et/ou l'enveloppe de boîtier étant extensible de façon appropriée,
le matériau de l'enveloppe de boîtier étant électro-isolant,
le volume intérieur du boîtier d'actionneur étant rempli au moins largement avec la masse d'isolation,
l'enveloppe de boîtier et le fond d'actionneur et le couvercle d'actionneur étant reliés de façon étanche entre eux vis à vis de la masse d'isolation et du fluide enveloppant,
la masse d'isolation étant un fluide électro-isolant et/ou un gel, et
la conductibilité thermique de la masse d'isolation étant égale ou supérieure à celle du matériau de la pile piézo-électrique,
**caractérisé en ce que**
le volume intérieur du boîtier d'actionneur est au moins largement exempt de gaz et
**en ce que** la viscosité du fluide d'isolation (3) correspond à peu près à celle du fluide enveloppant.

2. Actionneur piézo-électrique selon la revendication 1, **caractérisé en ce que** la pile piézo-électrique (3) présente de la céramique piézo-électrique.

3. Actionneur piézo-électrique selon la revendication 1, **caractérisé en ce que** le couvercle d'actionneur (5a) et le fond d'actionneur (5b) étant équidistants l'un de l'autre.

4. Actionneur piézo-électrique selon la revendication 1, **caractérisé en ce que** le couvercle d'actionneur (5a) et le fond d'actionneur (5b) présentent une surface de section différente.

5. Actionneur piézo-électrique selon la revendication 1, **caractérisé en ce que** la masse d'isolation (3) est une huile de silicone.

6. Actionneur piézo-électrique selon la revendication 1, **caractérisé en ce que** le couvercle d'actionneur (5a) et/ou le fond d'actionneur (5b) présentent une surface de section qui correspond respectivement à la surface active, attribuée et disposée transversalement à la direction d'extension principale de la pile piézo-électrique (1), de la pile piézo-électrique (1).

7. Actionneur piézo-électrique selon la revendication 1, **caractérisé en ce que**, le fond d'actionneur (5a) et/ou le couvercle d'actionneur (5b) présente au moins deux zones de terminaison isolées électriquement l'une de l'autre pour les lignes de raccordement (2) électriques de la pile piézo-électrique (1).

8. Utilisation d'un actionneur piézo-électrique selon la revendication 1 pour une vanne d'injection, en particulier d'un moteur à combustion interne, de préférence un moteur à allumage commandé ou un moteur diesel.

9. Utilisation d'un actionneur piézo-électrique selon la revendication 1 pour une vanne proportionnelle.

10. Utilisation d'un actionneur piézo-électrique selon la revendication 1 pour une sonotrode.
